# EUROPÄISCHE PATENTSCHRIFT

(11) **EP 2 156 713 B1**
(45) Veröffentlichungstag und Bekanntmachung des Hinweises auf die Patenterteilung: **13.02.2013**
(21) Anmeldenummer: 08717788.7
(22) Anmeldetag: 13.03.2008
(51) Int. Cl.: H05K 3/10, H05K 1/02, H05K 1/11, H05K 3/40

(54) **STEUERGERÄT EINES KRAFTFAHRZEUGS**
CONTROL DEVICE OF A MOTOR VEHICLE
DISPOSITIF DE COMMANDE D'UN VÉHICULE AUTOMOBILE

(30) Priorität: 31.05.2007 DE 102007025233
(43) Veröffentlichungstag der Anmeldung: 24.02.2010
(73) Patentinhaber: Robert Bosch GmbH, 70442 Stuttgart (DE)
(72) Erfinder: WERNER, Michael, 31139 Hildesheim (DE); LACHENMAIER, Armin, 73635 Rudersberg-Schlechtbach (DE); LISCHECK, Andre, 71665 Vaihingen (DE); SCHULZ, Udo, 71665 Vaihingen/Enz (DE); PROEPPER, Thomas, 72762 Reutlingen (DE); DIEKE, Stephan, 38302 Wolfenbuettel (DE); BARTH, Heinrich, 71229 Leonberg (DE); HENNEL, Udo, 74321 Bietigheim-Bissingen (DE); KIRSCHNER, Manfred, 70197 Stuttgart (DE)
(86) Internationale Anmeldenummer: PCT/EP2008/053044
(87) Internationale Veröffentlichungsnummer: WO 2008/145425

(56) Entgegenhaltungen:
- EP-A- 0 520 740
- EP-A- 1 045 627
- EP-A- 1 328 142
- DE-A1- 3 737 889
- DE-B3- 10 301 516
- DE-U1- 9 421 278
- US-A- 4 994 783
- US-A- 5 535 903
- DATABASE WPI Week 200713 Thomson Scientific, London, GB; AN 2007-132275 XP002485808 & WO 2006/126606 A (TECHNO POLYMER CO LTD) 30. November 2006 (2006-11-30)
- A.M. LITMAN, N.E. FOWLER: "Electromagnetic shielding utilizing conductive thermoplastic structural foam" XEROX DISCLOSURE JOURNAL, Bd. 8, Nr. 2, 1983, Seiten 115-116, XP002485807

## Beschreibung

Die Erfindung betrifft ein Steuergerät eines Kraftfahrzeugs, vorzugsweise Motorsteuergerät des Kraftfahrzeugs, mit mindestens einem Kunststoffsubstrat, dem mindestens ein mit einer Dotierung au thermisch leit fähigen Partikeln gebildetes Kühlelement zugeordnet ist.

Ferner betrifft die Erfindung ein Verfahren zum Herstellen eines Kunststoffsubstrats für ein Steuergerät eines Kraftfahrzeug

### Stand der Technik

Bekannte Steuergeräte von Kraftfahrzeugen weisen in der Regel ein Kunststoffsubstrat auf, dem ein elektrisch leitfähiges und/oder thermisch leitfähiges Element, wie zum Beispiel elektrische Leiterbahn oder ein Kühlelement zugeordnet ist. Bei der heutigen Montage derartiger Steuergeräte wird das Element in der Regel durch die Anwendung der sogenannten SMT-Technik (Surface Mounted Technique = Oberflächenmontage) auf der Oberfläche des Kunststoffsubstrats befestigt. Dabei wird das Element beispielsweise an dem Kunststoffsubstrat verschraubt, verklebt oder verklemmt. Dies führt zu einer Vielzahl von notwendigen Montageschritten zur Fertigung eines derartigen, bekannten Steuergeräts eines Kraftfahrzeugs. Darüber hinaus sind kompliziertere Schaltungen nur mit einem hohen Montage- und Konstruktionsaufwand realisierbar.

DE 37 37 889 offenbart ein Kunststoff substrat, dem ein mit einer Dotierung aus thermisch leitfähigen Partikeln gebildetes Kühlelement zugeordnet ist.

### Offenbarung der Erfindung

Erfindungsgemäß ist vorgesehen, dass das Kunststoffsubstrat an seiner Außenseite mehrere Kühlrippen bildende Vorsprünge des Kühlelements aufweist, die mit einer Dotierung aus thermisch leitfähigen Partikeln versehen sind, wobei die Kühlrippen mit einer Metall pulver beschichtung versehen sind.

Dadurch wird das thermisch leitfähige Element von dem eigentlich nicht leitfähigen Substrat selbst (mit-)gebildet, wodurch, unter Anderem, eine besonders bauraumsparende Anordnung möglich ist. Darüber hinaus ist es möglich, das Element überall in oder an dem Kunststoffsubstrat anzuordnen, wodurch komplexe Verschaltungen einfach realisierbar sind. Das Kunststoffsubstrat übernimmt die mechanische Fixierung des Elements sowie den Schutz für das Element vor äußeren Einwirkungen. Das Element ist dann sozusagen von dem Substrat ummoldet beziehungsweise eingehaust. Durch die vorteilhafte Ausbildung ist das Steuergerät somit besonders stabil und beständig ausgebildet. Die Dotierung kann beispielsweise im flüssigen/viskosen Zustand des Kunststoffsubstrats in das Kunststoffsubstrat injiziert werden, um es gezielt zu platzieren.

Nach einer Weiterbildung der Erfindung bildet die Dotierung eine elektrische und/oder thermische Verbindung. Vorteilhafterweise ist in und/oder an dem Kunststoffsubstrat mindestens ein elektrisches/elektronisches und/oder thermisches Bauteil angeordnet, welches über die von der Dotierung gebildeten thermischen Verbindung kontaktiert wird. Die Verbindung wird vorteilhafterweise durch lokales Aufschmelzen mittels mindestens eines Laserstrahls und/oder mittels mindestens eines gerichteten elektrischen und/oder magnetischen zumindest lokalen Feldes hergestellt. Mittels des Laserstrahls kann zum Beispiel ein lokales Aufschmelzen des Kunststoffsubstrats erreicht werden, das zum Fliessen der leitfähigen Dotierung zu einer elektrisch leitfähigen Verbindung führt, die eine weite Strecke in dem Kunststoffsubstrat überbrücken kann. Vorteilhafterweise weist das Kunststoffsubstrat dazu zumindest im Bereich der Dotierung eine schaumartige Struktur auf. Auch ist es denkbar lokal einen flüssigen/viskosen Zustand des Kunststoffsubstrats herzuführen, in dem durch ein gerichtetes elektrisches und/oder magnetisches Feld die elektrische und/oder thermische Verbindung hergestellt wird. Auch kann die Verbindung eine durch punktuellen Druck auf das Kunststoffsubstrat im Bereich der Dotierung erstellte Verbindung sein, wobei das Kunststoffsubstrat lokal soweit zusammengedrückt wird, dass eine thermische leitfähige Verbindung hergestellt wird.

Vorteilhafterweise ist auch dazu das Kunststoffsubstrat zumindest lokal verflüssigt oder viskos.

Vorteilhafterweise weist das thermisch leitfähige Element durch Laserschnitt mindestens eine Trennstelle auf. So kann beispielsweise vorgesehen sein, dass die thermisch leitfähige Verbindung eine durch Laserschnitt erstellte Trennstelle aufweist. Hierbei ist es denkbar ein Kunststoffsubstrat bereitzustellen, dem mehrere thermische Bauteile zugeordnet sind, welche über mehrere vorteilhafte thermische Verbindungen miteinander in Kontakt stehen. Vorteilhafterweise ist das Kunststoffsubstrat derart gestaltet, dass sämtliche mögliche Verbindungen zwischen den Bauteilen bestehen. Durch Laserschnitt kann hierbei durch Durchtrennen von zumindest einer der bestehenden Verbindungen eine gewünschte Verschaltung der Bauteile miteinander erstellt werden. Für die spätere Anwendung müssen also nur die nicht gewünschten Verbindungen getrennt werden, wobei dies auf einfache Art und Weise wie oben beschrieben geschehen kann.

Die Dotierung bildet mindestens ein Kühlelement. Dazu ist die Dotierung zweckmäßigerweise als thermisch leitfähige Wärmebrücke ausgebildet und durch lokales Injizieren und/oder Ausrichten im Künststoffsubstrat realisiert. Vorteilhafterweise wird die thermisch leitfähige Dotierung, zum Beispiel mittels eines Laserstrahls, aufgeschmolzen, um eine lokale Erhöhung der Wärmeleitfähigkeit zu erreichen. Durch diese Erhöhung entstehen praktisch lokale sogenannte Thermal-Vias oder -Inlays. Vorteilhafterweise ist die das Kühlelement bildende Dotierung derart im Kunststoffsubstrat angeordnet und ausgerichtet, dass Wärme vom Inneren des Kunststoffsubstrats nach außen transportiert wird. An der Oberfläche des Substrats ist zusätzlich eine Beschichtung mit Metallpulver, wie zum Beispiel eine thermoplastisch basierte Dispersionen mit Kohlenstoffeisenpulver, vorgesehen, um das Wärmeabstrahlverhalten zu verbessern.

Die Dotierung ist von thermisch leitfähigen Partikeln und/oder Fasern gebildet. Vorteilhafterweise ist die Dotierung von runden, stabförmigen und/oder anders geformten Metallpartikeln beziehungsweise -Fasern, wie zum Beispiel mit Kupferfasern gefüllte Polyamide oder auch Nanotubes (kleinste Röhrchen) aus Carbon (Kohlenstoff), gebildet.

Vorteilhafterweise sind die Partikel und/oder Fasern bei zumindest lokal viskosem/flüssigen Kunststoffsubstrat durch Anlegen eines elektromagnetischen Feldes und/oder durch Gravitation ausgerichtet und/oder verlagert.

Das erfindungsgemäße Verfahren sieht vor, dass das Kunststoffsubstrat zumindest bereichsweise für die Ausbildung einer thermisch leitfähigen Struktur dotiert wird. Dadurch lassen sich in dem Kunststoffsubstrat thermisch leitfähige Elemente bilden.

Bevorzugt wird das Kunststoffsubstrat beziehungsweise die Dotierung zum Bilden der Struktur durch direkten oder indirekten Wärmeeintrag, zum Beispiel mittels eines Laserstrahls, aufgeschmolzen. Wobei das Aufschmelzen der Dotierung dazu führen kann, dass eine Verbindung erstellt oder zerstört wird. Das Kunststoffsubstrat wird vorteilhafterweise zumindest im Bereich der Dotierung schaumartig hergestellt.

Vorteilhafterweise wird die Dotierung zur Bildung der Struktur in zumindest lokal flüssigem Zustand des Kunststoffsubstrats mittels eines zumindest lokalen elektrischen und/oder magnetischen Feldes ausgerichtet.

Schließlich ist vorgesehen, dass die Dotierung derart ausgerichtet und/oder, beispielsweise durch Aufschmelzen, geformt wird, dass sie eine ein Kühlelement bildet.

### Kurze Beschreibung der Zeichnungen

Im Folgenden soll die Erfindung anhand einiger Figuren näher erläutert werden. Dazu zeigen:
- Figuren 1 A und 1 B: ein Beispiel eines Kunststoffsubstrats mit einer elektrischen Verbindung,
- Figuren 2A und 2B: ein zweites Beispiel für ein Kunststoffsubstrat mit einer elektrischen Verbindung,
- Figuren 3A bis 3C: ein Beispiel für ein Kunststoffsubstrat mit einer getrennten Verbindung,
- Figuren 4A bis 4C: ein Beispiel für ein Kunststoffsubstrat mit einer Steckverbindung,
- Figur 5: ein Beispiel für ein Kunststoffsubstrat mit einem integrierten Kondensator,
- Figur 6: ein Beispiel eines Kunststoffsubstrats mit einer schichtweisen Dotierung zur Verbesserung der Signalintegrität und
- Figur 7: ein Ausführungsbeispiel für ein vorteilhaftes Kunststoffsubstrat mit einem integrierten Kühlelement.

### Ausführungsform(en) der Erfindung

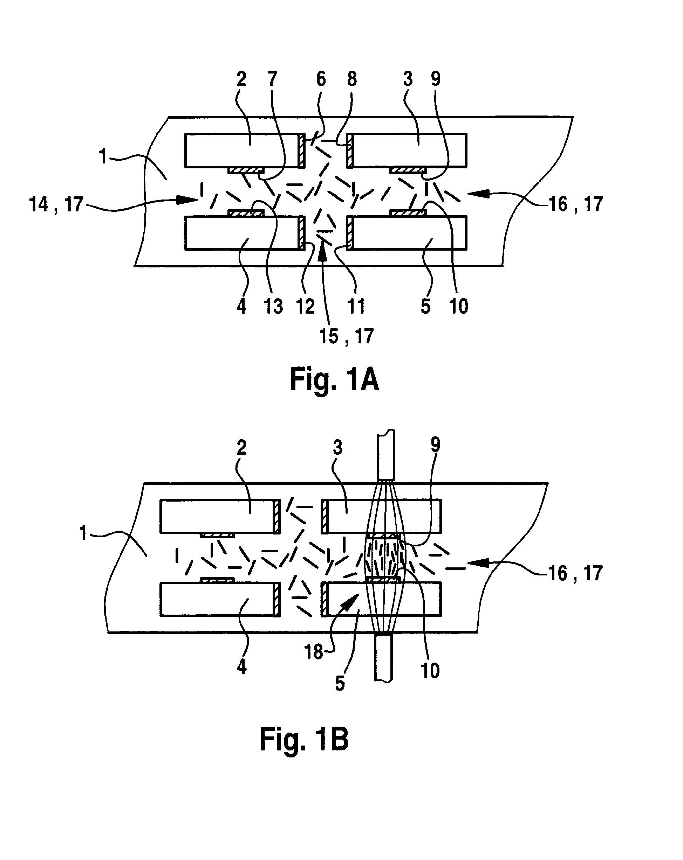

Die Figur 1 A zeigt in einer schematischen Darstellung ein Vergliechsbeispiel für ein Kunststoffsubstrat 1 eines hier nicht näher dargestellten Motorsteuergeräts eines Kraftfahrzeugs. In dem Kunststoffsubstrat 1 sind mehrere Elektronikbauteile 2 bis 5 angeordnet beziehungsweise von dem Kunststoffsubstrat 1 ummoldet/eingehaust. Jedes der Elektronikbauteile 2 bis 5 weist zwei elektrische Kontakte 6, 7 beziehungsweise 8, 9 beziehungsweise 10, 11 beziehungsweise 12, 13 auf, wobei jeweils ein elektrischer Kontakt 6 bis13 eines Bauteils 2 bis 5 einem elektrischen Kontakt 6 bis13 eines benachbarten Elektronikbauteils gegenüberliegt. Weiterhin weist das Kunststoffsubstrat 1 mehrere Bereiche auf, die mit einer elektrisch leitfähigen Dotierung 14, 15 und 16 versehen sind. Die jeweilige Dotierung 14, 15, 16 besteht aus als Metallfasern 17, die orientierungslos in dem Kunststoffsubstrat 1 liegen. Die Dotierungen 14 bis 16 sind dabei jeweils im Bereich zwischen zwei gegenüberliegenden elektrischen Kontakten 6 bis 13 angeordnet. Je nach Dichte der Dotierung 14 bis 16 ist keine oder eine mehr oder weniger stark ausgeprägte elektrische Verbindung zwischen den gegenüberliegenden elektrischen Kontakten 6 bis 13 gewährleistet. Bei der Herstellung des vorliegenden Kunststoffsubstrats 1 werden die Dotierungen 14 bis 16 beispielsweise im noch flüssigen/viskosen Zustand des Kunststoffsubstrats 1 in die entsprechenden Bereiche injiziert.

Die Figur 1 B zeigt das Kunststoffsubstrat 1 der Figur 1A, wobei die Dotierung 16 zwischen den Elektronikbauteilen 3 und 5 mittels eines extern angelegten magnetischen Felds 18 konzentriert und/oder ausgerichtet wird, sodass die Partikel 17 ein elektrisch leitfähiges Element, nämlich eine elektrisch leitfähige Verbindung von dem elektrischen Kontakt 9 des Elektronikbauteils 3 zu dem elektrischen Kontakt 10 des Elektronikbauteils 5 bilden. Das Kunststoffsubstrat 1 befindet sich dabei vorteilhafterweise noch im viskosen beziehungsweise flüssigen Zustand. Durch das lokal gerichtete magnetische Feld 18 werden die Metallfasern 17 ausgerichtet und gewährleistet, dass die elektrische Verbindung nur zwischen den Elektronikbauteilen 3 und 5 erstellt wird und die übrigen Dotierungen 15 und 14 nicht beeinträchtigt werden. Alternativ dazu ist es auch denkbar, das Kunststoffsubstrat 1 lokal im Bereich der Dotierung 16 zu verflüssigen und dann mittels eines elektrischen und/oder magnetischen Feldes die Dotierung 16 auszurichten.

Durch das in den Figuren 1A und 1B dargestellte Kunststoffsubstrat 1 beziehungsweise das Verfahren zum Herstellen der elektrischen Verbindung zwischen den Elektronikbauteilen 3 und 5, wie in den Figuren 1A und 1B dargestellt, ermöglicht das Erstellen von einer Vielzahl gleichartiger Kunststoffsubstrate, wobei die gewünschten elektrischen Verbindungen individuell auf einfache Art und Weise hergestellt werden. Dadurch ist eine hohe Variantenvielfalt auf Basis von gleichartigen Grund-Substraten einfach und kostengünstig herstellbar.

Alternativ zu dem Anlegen eines elektrischen und/oder magnetischen Feldes 18 ist es auch möglich, durch punktuellen Druck das Kunststoffsubstrat 1 im Bereich einer der Dotierungen 14, 15 oder 16 derart weit zusammenzudrücken, dass eine leitfähige elektrische Verbindung zwischen zumindest zwei der Elektronikbauteile 2 bis 5 entsteht. Wobei sich das Kunststoffsubstrat dazu zweckmäßigerweise in einem insbesondere lokal flüssigen oder viskosen Zustand befindet.

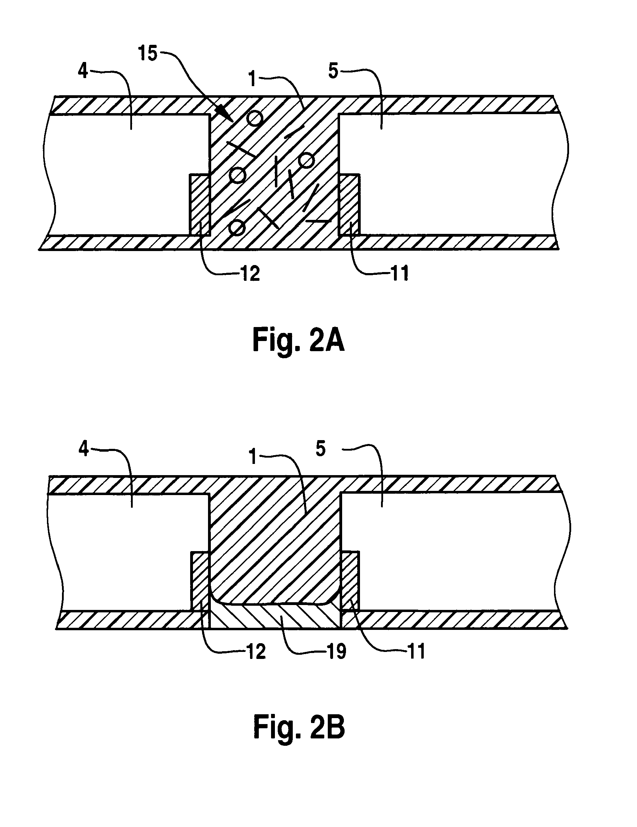

Die Figuren 2A und 2B zeigen eine weitere Möglichkeit zum Erstellen einer elektrischen Verbindung zwischen den zwei Elektronikbauteilen 4 und 5 aus den vorhergehenden Figuren in einem schematisch dargestellten Vergleichsbeispiel. Die Elektronikbauteile 4 und 5 sind am Bodenbereich des Kunststoffsubstrats 1 angeordnet, wobei sich ihre elektrischen Kontakte 11, 12, wie oben beschrieben, gegenüberliegen. Die Figur 2A zeigt die Dotierung 15, die von Metallpartikeln und/oder -Fasern gebildet wird, im nicht ausgerichteten beziehungsweise orientierungslosen Zustand. Um eine sichere elektrische Verbindung zwischen der Elektronikbauteile 4 und 5 herzustellen, wird vorteilhafterweise das Kunststoffsubstrat 1 sowie die Dotierung 15 im Bereich der Dotierung 15 durch Wärmeeintrag, beispielsweise mittels eines Laserstrahls, aufgeschmolzen. Dabei fließt die Dotierung 15 im Bodenbereich aufgrund der wirkenden Schwerkraft zusammen zu einer elektrischen Verbindung 19. Vorteilhafterweise ist das Kunststoffsubstrat 1 zumindest lokal im Bereich der Dotierung 15 schaumartig ausgebildet.

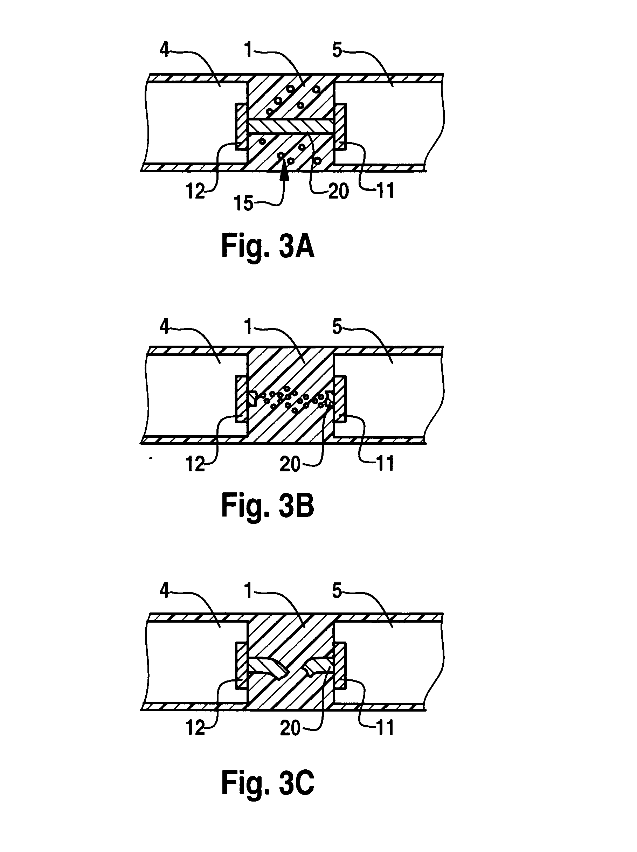

Die Figuren 3A bis 3C zeigen das Kunststoffsubstrat 1 in einem weiteren Vergleichsbeispiel. Figur 3A zeigt das Kunststoffsubstrat 1 im Ausgangszustand mit den Elektronikbauteilen 4 und 5, deren sich gegenüberliegende elektrische Kontakte 12 und 11 über eine mittels der Dotierung 15 erstellten elektrischen Verbindung 20 miteinander verbunden sind. Die elektrische Verbindung 20 kann dabei durch Anlegen eines elektromagnetischen Feldes im viskosen Zustand des Kunststoffsubstrats 1 erstellt worden sein. Bei der Herstellung des Kunststoffsubstrats 1 sind in diesem Ausführungsbeispiel sämtliche möglichen elektrischen oder thermischen Verbindungen zwischen den im Kunststoffsubstrat 1 angeordneten Elektronikbauteilen (2 bis 5) hergestellt. Um eine gewünschte Verschaltung zu erhalten, werden unerwünschte Verbindungen 20, wie in den Figuren 3B und 3C dargestellt, getrennt.

Die Figur 3B zeigt das Kunststoffsubstrat 1 aus der Figur 3A, wobei die elektrische Verbindung 20 durch lokalen Wärmeeintrag, beispielsweise mittels eines Laserstrahls, verdampft und somit die Elektronikbauteile 4 und 5 elektrisch voneinander getrennt wurden.

Die Figur 3C zeigt das Kunststoffsubstrat 1 aus der Figur 3A mit einer getrennten Verbindung 20, wobei hier im Gegensatz zu dem in der Figur 3B dargestellten Vergleichsbeispiel die Verbindung 20 aufgeschmolzen ist. Um das lokale Verdampfen oder Aufschmelzen der Verbindung zu erleichtern, ist das Kunststoffsubstrat vorteilhafterweise insbesondere im Bereich der Verbindung 20 schaumartig ausgebildet. Alternativ zu den in den Figuren 3B und 3C dargestellten Ausführungsbeispielen ist es auch denkbar, die elektrische Verbindung 20 in zumindest lokal flüssigem/viskosem Zustand des Kunststoffsubstrates durch ein entsprechend gerichtetes elektrisches und/oder magnetisches Feld zu trennen. Natürlich ist es auch möglich, im flüssigen/viskosen Zustand des gesamten Kunststoffsubstrats 1 die elektrische Verbindung 20 durch ein lokal gerichtetes elektrisches und/oder magnetisches Feld zu trennen.

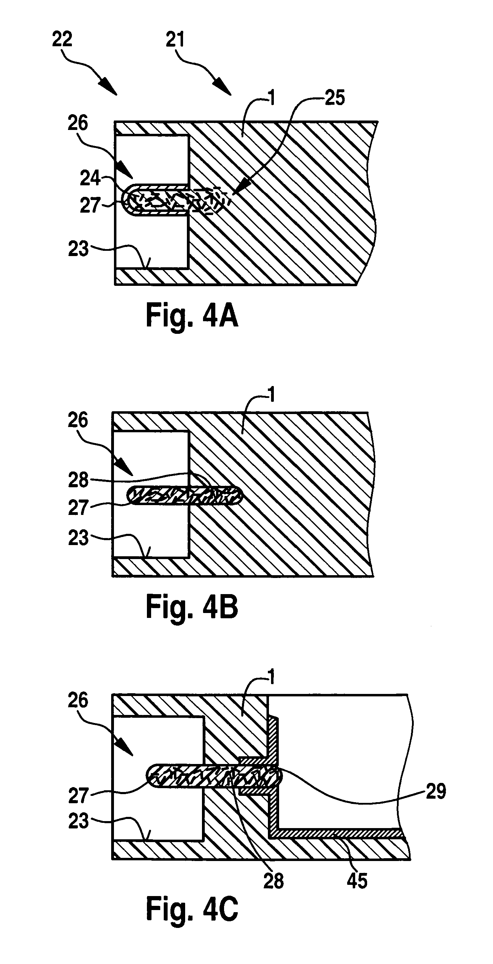

Die Figuren 4A bis 4C zeigen in einem Vergleichsbeispiel einen bisher nicht dargestellten Abschnitt des Kunststoffsubstrats 1. Der dargestellte Bereich ist als ein Teil einer Steckverbindung 21 ausgebildet. Dazu weist das Kunststoffsubstrat 1 an einem freien Ende 22 eine randoffene Aussparung 23 auf, in die ein stiftförmiger Vorsprung 24, der einstückig mit dem Kunststoffsubstrat 1 ausgebildet ist, derart hineinragt, dass ein in die Aussparung 23 eingestecktes Steckelement auf den Vorsprung 24 aufgeschoben werden kann. Im Bereich des Vorsprungs 24 weist das Kunststoffsubstrat 1 eine elektrisch leitfähige Dotierung 25 auf. Die elektrisch leitfähige Dotierung 25 ist derart konzentriert in dem Bereich des Vorsprungs 24 ausgebildet, dass der Vorsprung 24 als elektrischer Kontaktstift 26 (beziehungsweise elektrisch leitfähiges Bauelement 26) wirkt. Vorteilhafterweise ist die Oberfläche des Kontaktstifts 26 mit einer Metallisierung 27 versehen, um einen guten elektrischen Kontakt zu gewährleisten. Durch eine entsprechende Ausbildung und/oder Ausrichtung der Dotierung 25 kann der Kontaktstift 26 mit Elektronikbauteilen des Kunststoffsubstrats 1, insbesondere wie oben beschrieben, verbunden werden. In einer alternativen Ausführungsform der Steckverbindung 21, die hier nicht dargestellt ist, ist nicht ein mit einer Dotierung 25 versehener Vorsprung 24, sondern eine von einer Dotierung mit Kunststoffsubstrat umgebene Kontaktstiftaufnahme ausgebildet.

Um eine scharfe Abgrenzung zwischen dem leitfähigen, also dotiertem Bereich 25 des Kunststoffsubstrats 1 und dem nicht leitfähigen Bereich des Kunststoffsubstrats 1 zu erreichen, ist es denkbar, wie in der Figur 4B dargestellt, den Kontaktstift 26 aus dotiertem, elektrisch leitfähigem Kunststoffsubstrat 27 zu bilden, das in eine vorgesehene Aussparung 28 des nicht leitfähigen Kunststoffsubstrats 1 eingesteckt und vorteilhafterweise darin verklebt oder verschweißt ist. Ebenfalls ist es denkbar, das den Kontaktstift 26 bildende Kunststoffsubstrat 27 mittels mechanischen Press- oder Einrastlösungen in dem Kunststoffsubstrat 1 zu befestigen.

Die Figur 4C zeigt dazu den von dem Kunststoffsubstrat 27 gebildeten Kontaktstift 26, der in die Aufnahme 28 des Kunststoffsubstrats 1 eingesteckt ist. Auf der der Aussparung 23 gegenüberliegenden Seite des Kontaktstifts 26 liegt letzterer in einer Aufnahme 29 einer Leiterbahn 45 ein, die ebenfalls in dem Kunststoffsubstrat 1 ausgebildet beziehungsweise angeordnet ist.

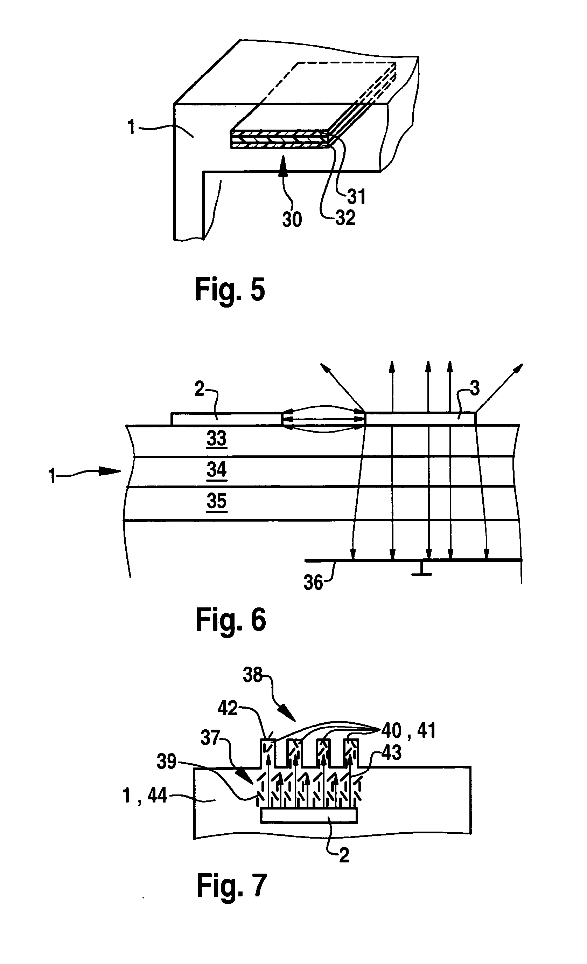

Die Figur 5 zeigt in einem weiteren Vergleichsbeispiel einen weiteren, bisher nicht dargestellten Abschnitt des Kunststoffsubstrats 1. Der dargestellte Bereich des Kunststoffsubstrats 1 weist einen integrierten Kondensator 30 auf, der von einer schichtweisen Dotierung gebildet ist. Die Kondensatorplatten des Kondensators 31 werden dabei von jeweils einer entsprechend angeordneten und ausgerichteten Dotierung 31 beziehungsweise 32 gebildet, wobei die Dotierungen 31, 32, wie oben beschrieben, angeordnet und ausgerichtet werden können. Durch Veränderung der dielektrischen Eigenschaft des Kunststoffsubstrats 1 im Bereich zwischen den Kondensatorplatten sind ebenfalls unterschiedliche Kapazitätswerte realisierbar. Dabei können zur Veränderung des Dielektrikums unterschiedliche Technologien verwendet werden. Zum einen kann durch Streckung und/oder Dehnung des Kunststoffsubstrats eine bestimmte Polarisation erreicht werden. Mittels eines Laserstrahls kann beispielsweise auch eine physikalische und/oder chemische Gefüge- und/oder Strukturänderung in dem Kunststoffsubstrat 1 und/oder der Dotierung 31, 32 erreicht werden.

Die Figur 6 zeigt in einem weiteren Vergleichsbeispiel in einer schematischen Darstellung das Kunststoffsubstrat 1, welches mehrere aneinanderliegende unterschiedlich dotierte Schichten 33, 34 und 35 aufweist. Weiterhin verläuft durch das Kunststoffsubstrat 1 ein insbesondere mehradriges Datenkabel 36, das hier nur vereinfacht dargestellt ist. Die unterschiedlichen Schichten 33 bis 35 weisen unterschiedliche Leitfähigkeit, Permeabilität und Permittivität auf, die durch eine entsprechende Dotierung, insbesondere in Bezug auf Ausrichtung, Gestaltgebung und Material, erreicht wird. Hierdurch wird die Signalintegrität des Datenkabels 36 erheblich verbessert, insbesondere in Bezug auf den Leitungswellen-Widerstand (Real- und Imaginärteil). Insbesondere wird die Signalintegrität hinsichtlich Reflektion, Übersprechen, Schirmdämpfung, Störaussendung- und -einstrahlfestigkeit und/oder ESD-Schutz (ElektroStatische-Entladungen) verbessert. Vorteilhafterweise ist das Kunststoffsubstrat in der Umgebung des Datenkabels 36 aufgeschäumt ausgebildet, um vorteilhafte Ausbreitungseigenschaften ("low-k" Substrat) insbesondere auf HDR (High Data Rate)-Leitungen zu erreichen. Mittels der in der Figur 6 dargestellten Ausbildung des Kunststoffsubstrats 1 lassen sich breitbandige Hochfrequenzfilter beziehungsweise Schirmungen, zum Beispiel gegenüber Signalmassen (36) aufbauen.

Die Figur 7 zeigt in einem Ausführungsbeispiel das Kunststoffsubstrat 1 mit einem von einer Dotierung 37 gebildeten Kühlelement 38. Die Dotierung 37 ist von thermisch leitfähigen Partikeln 39 gebildet, die mittels eines elektrischen und/oder magnetischen Feldes derart ausgerichtet wurden, dass Wärme vom Inneren, insbesondere von dem Elektronikbauteil 2 nach außen transportiert wird. Das Kunststoffsubstrat 1 weist an seiner Außenseite mehrere Kühlrippen 40 bildende Vorsprünge 41 auf, die ebenfalls mit der Dotierung 37 versehen sind. Um eine verstärkte Wärmeabfuhr zu erreichen, können die Partikel 39 beispielsweise mittels eines Laserstrahls aufgeschmolzen werden, um lokale Anhäufungen thermisch leitfähiger Partikel 39 zu erreichen. Durch diese Verdichtung entstehen lokale Thermal-Vias oder Thermal-Inlays. Vorteilhafterweise sind die Kühlrippen 40 mit einer Metallpulverbeschichtung 42 versehen, um das Wärmeabstrahlverhalten zu verbessern. Die Dotierung 37 bildet hierbei also sowohl das Kühlelement 38 als auch eine thermisch leitfähige Verbindung 43 von zum Beispiel einem im Kunststoffsubstrat 1 angeordneten Elektronikbauteil nach außen. Vorteilhafterweise ist das Kunststoffsubstrat 1 als Gehäuseteil 44 des Motorsteuergeräts ausgebildet.

## Patentansprüche

1. Steuergerät eines Kraftfahrzeugs, vorzugsweise Motorsteuergerät des Kraftfahrzeugs, mit mindestens einem Kunststoffsubstrat (1), dem mindestens ein mit einer Dotierung aus thermisch leitfähigen Partikeln gebildetes Kühlelement (38) zugeordnet ist, **dadurch gekennzeichnet, dass** das Kunststoffsubstrat (1) an seiner Außenseite mehrere Kühlrippen (40) bildende Vorsprünge (41) des Kühlelements (38) aufweist, die mit einer Dotierung (37) aus thermisch leitfähigen Partikeln (39) versehen sind, wobei die Kühlrippen (40) mit einer Metallpulverbeschichtung (42) versehen sind.

2. Steuergerät nach Anspruch 1, **dadurch gekennzeichnet, dass** die Dotierung (37) eine thermische Verbindung (43) bildet.

3. Steuergerät nach einem der vorhergehenden Ansprüche, **dadurch gekennzeichnet, dass** die Dotierung (37) von thermisch leitfähigen Partikeln (39) gebildet ist, die mittels eines elektrischen und/oder magnetischen Felds derart ausgerichtet wurden, dass Wärme vom Inneren nach außen transportiert wird.

4. Steuergerät nach einem der vorhergehenden Ansprüche, **dadurch gekennzeichnet, dass** das Kunststoffsubstrat (1) zumindest als Gehäuseteil (44) des Steuergeräts ausgebildet ist.

5. Verfahren zum Herstellen eines Kunststoffsubstrats für ein Steuergerät eines Kraftfahrzeugs, nach einem oder mehreren der vorhergehenden Ansprüche, **dadurch gekennzeichnet, dass** das Kunststoffsubstrat an seiner Außenseite mit mehreren Kühlrippen (40) bildenden Vorsprüngen (41) des Kühlelements (38) versehen wird, die mit einer Dotierung (37) aus thermisch leitfähigen Partikeln (39) versehen sind, und mit einer Metallpulverbeschichtung (42) versehen werden.

6. Verfahren nach Anspruch 5, **dadurch gekennzeichnet, dass** zum Erreichen einer verstärkten Wärmeabfuhr die Partikel (39) aufgeschmolzen werden, um lokale Anhäufungen thermisch leitfähiger Partikel zu erreichen.

7. Verfahren nach Anspruch 5, **dadurch gekennzeichnet, dass** die Dotierung (37) von thermisch leitfähigen Partikeln (39) gebildet wird, die mittels eines elektrischen und/oder magnetischen Felds derart ausgerichtet werden, dass Wärme vom Inneren nach außen transportiert wird.

## Claims

1. Control device of a motor vehicle, preferably an engine control device of the motor vehicle, comprising at least one plastic substrate (1), to which at least one cooling element (38) formed with a doping of thermally conductive particles is associated, **characterized in that** the plastic substrate (1) has, on the outer side thereof, a plurality of protrusions (41) of the cooling element (38), which form cooling fins (40) and which are provided with a doping (37) of thermally conductive particles (39), wherein the cooling fins (40) are provided with a metal powder coating (42).

2. Control device according to Claim 1, **characterized in that** the doping (37) forms a thermal bond (43).

3. Control device according to either of the preceding claims, **characterized in that** the doping (37) is formed by thermally conductive particles (39), which have been oriented by means of an electric and/or magnetic field in such a manner that heat is transported from the inside outwards.

4. Control device according to one of the preceding claims, **characterized in that** the plastic substrate (1) is formed at least as a housing part (44) of the control device.

5. Process for producing a plastic substrate for a control device of a motor vehicle according to one or more of the preceding claims, **characterized in that** the plastic substrate is provided, on the outer side thereof, with a plurality of protrusions (41) of the cooling element (38), which form cooling fins (40) and which are provided with a doping (37) of thermally conductive particles (39) and are provided with a metal powder coating (42).

6. Process according to Claim 5, **characterized in that**, to achieve an intensified dissipation of heat, the particles (39) are melted, in order to achieve local accumulations of thermally conductive particles.

7. Process according to Claim 5, **characterized in that** the doping (37) is formed by thermally conductive particles (39), which are oriented by means of an electric and/or magnetic field in such a manner that heat is transported from the inside outwards.

## Revendications

1. Appareil de commande pour véhicule automobile, de préférence appareil de commande de moteur du véhicule automobile, présentant au moins un substrat (1) en matière synthétique auquel est associé au moins un élément de refroidissement (38) formé d'un dopage de particules thermiquement conductrices,
**caractérisé en ce que**
le substrat (1) en matière synthétique présente sur son côté extérieur plusieurs saillies (41) de l'élément de refroidissement (38) qui forment des nervures de refroidissement (40) et qui sont dotées d'un dopage (37) en particules (39) thermiquement conductrices, les nervures de refroidissement (40) étant dotées d'un revêtement (42) de poudre métallique.

2. Appareil de commande selon la revendication 1, **caractérisé en ce que** le dopage (37) forme une liaison thermique (43).

3. Appareil de commande selon l'une des revendications précédentes, **caractérisé en ce que** le dopage (37) est formé de particules (39) thermiquement conductrices qui ont été orientées au moyen d'un champ électrique et/ou d'un champ magnétique de telle sorte que la chaleur soit transportée de l'intérieur vers l'extérieur.

4. Appareil de commande selon l'une des revendications précédentes, **caractérisé en ce que** le substrat (1) en matière synthétique est configuré au moins comme partie (44) du boîtier d'un appareil de commande.

5. Procédé de fabrication d'un substrat en matière synthétique pour appareil de commande de véhicule automobile selon l'une des revendications précédentes, **caractérisé en ce que** le substrat en matière synthétique est doté sur son côté extérieur de saillies (41) de l'élément de refroidissement (38) qui forment plusieurs nervures (40) de refroidissement et dotées d'un dopage (37) en particules (39) thermiquement conductrices, et d'un revêtement (42) en poudre métallique.

6. Procédé selon la revendication 5, **caractérisé en ce que** pour obtenir une évacuation renforcée de la chaleur, les particules (39) sont fondues pour obtenir des accumulations locales de particules thermiquement conductrices.

7. Procédé selon la revendication 5, **caractérisé en ce que** le dopage (37) est formé de particules (39) thermiquement conductrices qui sont orientées au moyen d'un champ électrique et/ou d'un champ magnétique de telle sorte que la chaleur soit transportée de l'intérieur vers l'extérieur.
